# EUROPEAN PATENT SPECIFICATION

(11) **EP 0 402 039 B1**
(45) Date of publication and mention of the grant of the patent: **10.01.1996**
(21) Application number: 90305919.4
(22) Date of filing: 31.05.1990
(51) Int. Cl.: C23C 16/26, H01L 31/028, H01L 33/00

(54) **Method of depositing diamond and diamond light emitting device**
Verfahren zur Ablagerung von Diamant und Vorrichtung aus Diamant zur Lichtemission
Procédé pour le dépôt de diamant et appareil d'émission du rayonnement fabriqué à partir de diamant

(30) Priority: 05.06.1989 JP 143554/89; 05.06.1989 JP 143555/89; 12.06.1989 JP 149177/89
(43) Date of publication of application: 12.12.1990
(73) Proprietor: SEMICONDUCTOR ENERGY LABORATORY CO., LTD., Atsugi-shi Kanagawa-ken, 243 (JP)
(72) Inventor: Kadono, Masaya, Atsugi-shi, Kanagawa-Ken, 243 (JP); Yamazaki, Shunpei, Setagaya-ku, Tokyo 157 (JP)
(74) Representative: Milhench, Howard Leslie

(56) References cited:
- EP-A- 0 272 418
- EP-A- 0 288 065
- EP-A- 0 305 903
- DD-A- 133 688

## Description

### BACKGROUND OF THE INVENTION

### 1. Field of the Invention

The present invention relates to a method of depositing diamond films having uniform thickness by means of microwave enhanced CVD, and to a light emitting device formed by this method.

### 2. Description of the Prior Art

Many attempts have been proposed to deposit diamond films by microwave assisted CVD, since diamond is regarded as being promising as a future material for electronic devices. Diamond light emitting devices have attracted the interest of many researchers, because of the high thermal resistance, chemical stability and low price of diamond films which makes them suitable for mass production and capable in principle of satisfying the great demand for light emitting devices that exists in the marketplace. An example of such devices is described in Japanese Patent Application No. Sho 56-146930. It is, however, very difficult to deposit high quality diamond films having uniform thicknesses at the high deposition speeds required for production on a commercial basis.

The deposition conditions of prior art diamond formation techniques by microwave enhanced CVD have required the reactive gas to be composed of a hydrocarbon diluted by hydrogen at about 1-5%, the pressure of the reactive gas during deposition to be about 670 to 2670 N/m (5-20 Torr), the input power of the microwave energy to be 1-5 kW, and the deposition to be carried out in a magnetic field of 0.2 Tesla (2 kG). Crystal surfaces can be observed by a microscope even in the surface of diamond films deposited by such a prior art method. The deposition speeds achieved by these prior art deposition methods, however, have been limited to about 66.7 nm (667 angstroms) thickness per hour, i.e. it takes 15 hours to deposit a one micrometer thick diamond film. Furthermore, the area coated by diamond is limited to only 3 cm if the variation in film thickness is to be kept within 10%. Still further, the quality of the diamond that is deposited is not so high. Graphite is also deposited and is mixed into the diamond films. The graphite component has been confirmed by Raman spectroscopic analysis.

It is also known to use carbon monoxide diluted by hydrogen at 1-5%. The pressure in the reaction chamber in this case is 13 to 133 N/m (0.1 - 1 Torr). The deposition speed, however, is also low. It takes more than 10 hours to deposit a diamond film of one micrometer thickness even when input energy is applied at 3-5 kW. The area within which a uniform diamond film can be deposited is only up to 5 cm. A more problematic disadvantage of this method is etching of the inner walls of the chamber. The etching causes metallic contamination in the diamond films that are deposited. The metal is such as Fe constituting the wall. This contamination was confirmed by Auger electron spectroscopy. The etching product is also coated onto the window through which microwave energy is admitted to the chamber and forms an impediment to the introduction of microwave energy.

EP 0 305 903 describes a method of synthesis of diamond by contacting a substrate with a mixed gas of carbon source gas and hydrogen gas activated by irradiation with microwave energy to produce a plasma. The microwave energy is introduced from a plurality of directions to the substrate.

### SUMMARY OF THE INVENTION

It is an object of the present invention to provide a method of depositing diamond films of high quality at high speed.

It is another object of the present invention to provide a diamond light emitting device having excellent emission performance.

Therefore, according to the present invention there is provided a method of depositing diamond comprising:
disposing a substrate to be coated within a reaction chamber;
introducing a carbon compound gas including a C-OH bond together with hydrogen into the reaction chamber;
inducing a magnetic field in said reaction chamber; and
inputting microwave energy to said reaction chamber in order to deposit a carbon film comprising diamond on said substrate;
the volume ratio of said carbon compound gas to hydrogen introduced into said reaction chamber being 0.4 to 2, the pressure in said reaction chamber being 1.3 to 400 N/m (0.01 to 3 Torr), the temperature of said substrate being kept between 200 to 1000 °C during deposition, and the input energy of said microwave being no lower than 2 kW.

The most effective flow speed of the reactive gas passing through the deposition space is 30 to 600 cm/sec, and preferably 35 to 200 cm/sec. The features of the present invention include the relatively high flow speed, the relatively low pressure and the relatively high proportion of carbon compound gas to hydrogen as compared with conventional methods. By virtue of this method, diamond films consisting of sp³ bonds can be deposited to within 10% disparity in thickness at deposition rates no lower than 0.5 micrometer/hour, and typically no lower than 1 micrometer/hour.

In accordance with a method embodying the present invention, oxygen atoms are automatically introduced into the diamond films. The oxygen atoms function as recombination centers and when the diamond films are applied as light emitting devices the emission efficiency is improved. The atomic density of oxygen in the deposited diamond is for example 1 x 10¹⁸ to 6 x 10⁰ cm ⁻¹. The diamond films can be doped with impurities such as P or B in order to make impurity semiconductor films of n- or p- type. For n-type semiconductors, a Group VIb dopant can also be used. The Group VIb element imparts n-type conductivity to the semiconductors by causing lattice defects rather than by functioning as a donor.

It is very important for the present invention to use a carbon compound gas having a C-OH bond. When CO or CO₂ is used together with such as CH₄ as in conventional methods, diamond films containing oxygen atoms can be deposited. The films are, however, inevitably contaminated by iron ions derived by etching of the inner wall of the reaction chamber. In this conventional case, oxygen ions are produced as lone atoms which exert a strong etching action upon the reaction chamber wall. It is believed that in the case of the present invention OH or H₂O radicals are produced instead of lone O atoms. The etching effect of such OH or H₂O radicals is not so strong as to remove iron from the inner wall of the reaction chamber but advantageously is sufficient to remove graphite from the deposited diamond.

Other features and aspects of the invention are set forth with particularity in the appended claims and, together with the abovedescribed features, will be well understood by those skilled in the art from a reading of the following description of exemplary embodiments given with reference to the accompanying drawings.

### BRIEF DESCRIPTION OF THE DRAWINGS

Fig. 1 is a cross sectional view of an exemplary chemical vapour reaction apparatus for depositing diamond in accordance with the present invention;
Fig. 2 is a graphic diagram showing the result of Raman spectroscopic analysis of a diamond film deposited in accordance with the present invention;
Figs. 3 and 4 are photographs showing the surface conditions of diamond films deposited in accordance with the present invention;
Fig. 5 is a graphic diagram showing XRD spectra of a diamond film deposited in accordance with the present invention;
Figs. 6(A) to 6(C) are cross sectional views showing a method of manufacturing exemplary diamond light emitting devices in accordance with the present invention; and
Figs. 7(A) to 7(C) are cross sectional views showing a modification of the method of manufacturing a light emitting device illustrated in Figs. 6(A) to 6(C).

### DETAILED DESCRIPTION OF THE EMBODIMENTS

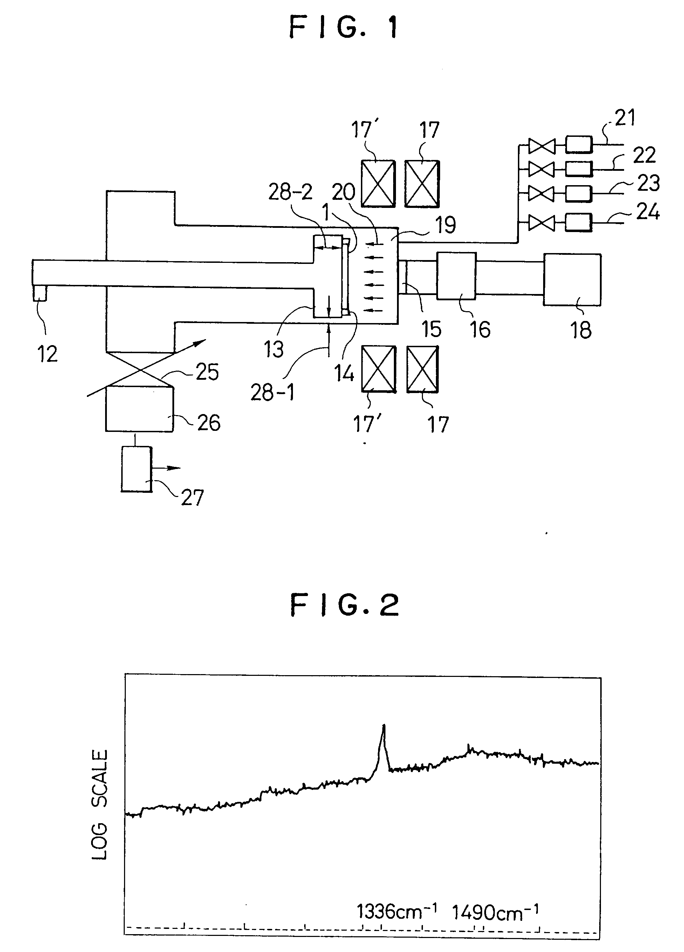

Referring now to Fig. 1, a microwave-assisted CVD apparatus provided with associated Helmholtz coils 17 and 17' for use in depositing diamond films in accordance with the present invention is shown. The apparatus comprises a vacuum chamber defining a reaction (deposition) space 19 therein, a microwave generator 18 connected to the chamber through an attenuator 16 and a quartz window 15, a gas introduction system having four inlet ports 21 to 24, a gas evacuation system including a wide-range turbo molecular pump 26 and a rotary pump 27 for roughing coupled with the chamber through a pressure controlling valve 25, and a substrate holder 13 provided in the chamber and including a substrate position adjusting mechanism 12 for supporting a substrate 1 at an appropriate position. By use of the adjusting mechanism 12, the axial position of the holder can be adjusted in order to change the volume of the reaction space 19. The evacuation system functions both as a pressure controller and as a stop valve. The pressure in the chamber is adjusted by means of the valve 25. The inside of the chamber and the holder 13 are circular and coaxial with each other. The diameter of the circular inside of the chamber is 170 mm. The diameter 28-1 of the circular holder 13 is chosen to be 140 mm so that the clearance between the chamber wall and the holder 13 is about 15 mm. The thickness 28-2 of the holder 13 is 10 to 50 mm. The clearance may be between 3 and 30 mm in general. By virtue of this configuration, the reaction space 19 is confined in order not substantially to lose input energy and only about 5% of the microwave energy that is inputted is reflected.

Next, a method of depositing diamond films embodying the invention by means of the apparatus of Fig. 1 will be described. The substrate is, for example, a single crystalline silicon semiconductor wafer of 5 to 15 cm (2 to 6 inches), e.g. 10 cm (4 inches), diameter. The surface of the substrate is preferably scratched to form focuses for crystalline growth. The scratches are formed, for example, by putting the substrate in a liquid in which fine diamond particles are dispersed and applying ultrasonic waves thereto for 1 minute to 1 hour, or by bombarding the surface with diamond powder. After fixing the substrate 1 on the holder 13 with a keeper 14, the pressure in the reaction space 19 is reduced to 1.3 x 10⁻ to 1.3 x 10⁻¹⁵ N/m (10⁻⁴ to 10⁻¹⁷ Torr) by means of the evacuation system followed by introduction of a reactive gas to a pressure of 1.3 to 400 N/m (0.01 to 3 Torr), typically 13.3 to 133 N/m (0.1 to 1 Torr) , e.g. 35 N/m (0.26 Torr). The reactive gas comprises an alcohol such as methyl alcohol (CH₃OH) or ethyl alcohol (C₂H₅OH) diluted with hydrogen at a volume ratio of alcohol/hydrogen of 0.4 to 2. The hydrogen is introduced through the port 21 at 100 SCCM and the alcohol through the port 22 at 70 SCCM for example. The coils are energized during the deposition to induce a magnetic field having a maximum strength of 0.2 Tesla (2 k Gauss) and a resonating strength of 0.0875 Tesla (875 Gauss) at the surface of the substrate 1 to be coated. Then, microwave energy is applied at 1 to 5 GHz, e.g. 2.45 GHz, in the direction parallel to the direction of the magnetic field to cause ionized particles of the reactive gas in the form of plasma to resonate therewith in the magnetic field. As a result, a polycrystalline film of diamond grows on the substrate. A 2 hour deposition for example can form a diamond film of 0.5 to 5 micrometer thickness, e.g. 1.3 micrometers thickness. During the deposition of the diamond film, carbon graphite is also deposited. However, the graphite, which is relatively chemically unstable as compared with diamond, reacts with radicals which also occur in the plasma of the alcohol and is removed from the deposited film. The temperature of the substrate 1 is elevated to 200 °C to 1000 °C typically 300 °C to 900 °C, e.g. 800 °C, by the microwave energy. If the substrate temperature is too elevated, water cooling of the substrate holder 13 may be effected.

The flow rate of the reactive gas 20 in the reaction space 19 is regulated by controlling the valve 25. By virtue of the molecular pump 26, the rate can be adjusted from 15 cm/sec up to 1000 cm/sec even at 1.3 N/m (0.01 Torr) in the reaction space 19. From the view point of deposition performance, rates of 30 to 600 cm/sec typically 35 to 200 cm/sec are appropriate.

In accordance with experimental results, crystalline surfaces of single carbon crystals were clearly observed partially in the films even when deposited at a substrate temperature of 200 °C. When deposited at a substrate temperature of 300 °C, single crystalline surfaces were observed throughout the deposited films. Fig. 2 is a diagram showing Raman spectroscopic analysis of a diamond film deposited in accordance with the present invention. The sharp peak appearing at 1336 cm⁻¹ indicates the existence of diamond. There is hardly any peak at 1490 cm⁻¹ where the existence of graphite would be indicated. It has been confirmed by Auger electron spectrometry that no or only little iron or stainless steel contamination occurs in the deposited films. It has also been confirmed by secondary ion mass spectroscopy that the diamond films include oxygen atoms at a density of 1 x 10¹⁸ to 6 x 10⁰ cm⁻³. The oxygen concentration depends upon the pressure of the reactive gas and the microwave energy input during deposition.

Depending upon the intended applications of the diamond films impurities may be introduced into the diamond films during deposition. Examples of such impurities include B, S, Se and Te. In the case of B, B(CH₃)₃ may be introduced as a dopant together with the reactive gas at a volume ratio of dopant gas/alcohol of 0.005 to 0.03. In the case of S, H₂S or (CH₃)₂S may be introduced as a dopant together with the reactive gas at a volume ratio of dopant gas/alcohol of 0.001 to 0.03. In the same manner, H₂Se, H₂Te, (CH₃)₂Se and (CH₃)₂Te can be used as dopant gases. Also, elements of Group IIb such as Zn and Cd can be introduced using a dopant gas of hydrogen or an organic compound thereof, or elements of Group Vb can be introduced using NH₃, PH₃ or AsH₃ for example.

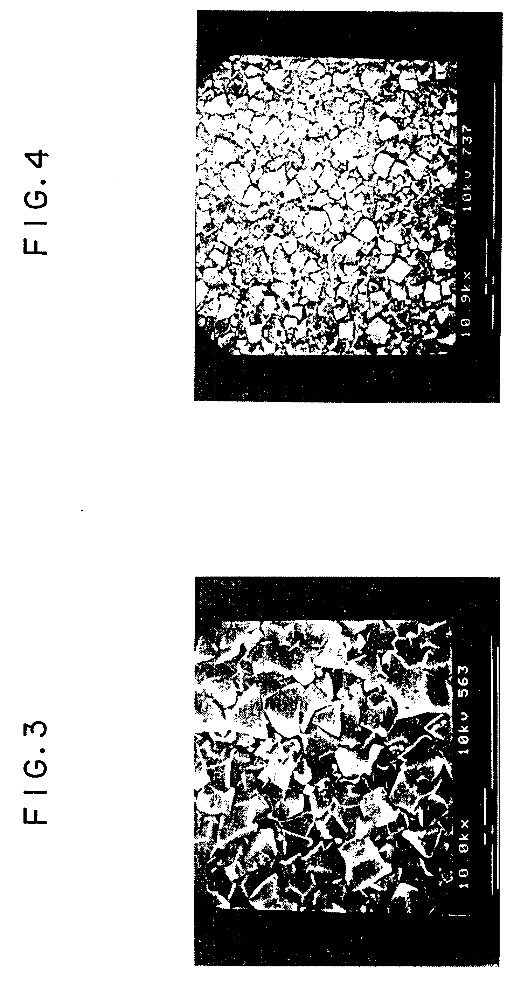

The above deposition process was repeated at diverse reaction pressures and with reactive gases diluted with hydrogen at diverse ratios. The alcohol used was methanol. The microwave energy was input at a power level of 2 kW. The crystalline condition of the diamond films that were deposited were examined by means of a scanning electron microscope and evaluated into three ranks as shown in the right hand column of Table 1 with correspondence to the volume ratio of CH₃OH/H₂, the substrate temperature and the pressure of the reactive gas (CH₃OH/H₂). In the table, the symbol ⓞ indicates that squares and/or triangles of crystal surfaces were observed throughout the diamond surface, the symbol ◇ indicates that the diamond surface was covered partially by crystal surfaces, and the symbol X indicates that no crystal surface was observed. Fig. 3 is a photograph showing the crystalline surface sample No. 1 for reference.

**Table 1**

| No. | Volume ratio of CH₃OH/H₂ | Temperature of substrate | Pressure of the gas | Condition of the film |
|---|---|---|---|---|
| 1 | 0.7 | 800°C | 27 Nm⁻ (0.2 Torr) | ⓞ |
| 2 | 0.8 | 600°C | 13 Nm⁻ (0.1 Torr) | ⓞ |
| 3 | 0.7 | 200°C | 27 Nm⁻ (0.2 Torr) | ◇ |
| 4 | 0.7 | 400°C | 4 Nm⁻ (0.03) Torr | ◇ |
| 5 | 0.4 | 800°C | 20 Nm⁻ (0.15 Torr) | ⓞ |
| 6 | 0.4 | 800°C | 400 Nm⁻(3.0 Torr) | ◇ |
| 7 | 2.0 | 800°C | 36 Nm⁻ (0.27 Torr) | ◇ |
| 8 | 0.6 | 800°C | 666 Nm⁻ (5.0 Torr) | X |
| 9 | 0.6 | 800°C | 1 Nm⁻ (0.01 Torr) | X |

**Table 2**

| No. | Pressure N/m(Torr) | H₂ (l/min) | CH₃OH (l/min) | Total (l/min) | F.Speed (cm/s) |
|---|---|---|---|---|---|
| 1 | 4.0(0.03) | 2533 | 1773 | 4266 | 313 |
| 2 | 13.3(0.1) | 760 | 532 | 1292 | 95 |
| 3 | 34.7(0.26) | 292 | 204 | 496 | 36.4 |
| 4 | 80.0(0.6) | 126 | 88.2 | 214 | 15.7 |
| 5 | 133.3(1.0) | 76 | 53.2 | 129 | 9.5 |
| 6 | 4.0(0.03) | 2533 | 2533 | 5066 | 372 |
| 7 | 13.3(0.1) | 760 | 760 | 1520 | 111.8 |
| 8 | 34.7(0.26) | 292 | 292 | 584 | 42.9 |
| 9 | 80.0(0.6) | 126 | 126 | 252 | 18.5 |
| 10 | 133.3(1.0) | 76 | 76 | 152 | 11.2 |
| 11 | 4.0(0.03) | 2533 | 5066 | 7599 | 558 |
| 12 | 13.3(0.1) | 760 | 1520 | 2280 | 167.6 |
| 13 | 34.7(0.26) | 292 | 584 | 876 | 64.4 |
| 14 | 80.0(0.6) | 126 | 252 | 378 | 27.4 |
| 15 | 133.3(1.0) | 76 | 152 | 228 | 16.8 |
| 16 | 4.0(0.03) | 2533 | 1266.5 | 3799.5 | 279 |
| 17 | 13.3(0.1) | 760 | 380 | 1140 | 83.8 |
| 18 | 34.7(0.26) | 292 | 146 | 438 | 32.2 |
| 19 | 80.0(0.6) | 126 | 63 | 189 | 13.9 |
| 20 | 133.3(1.0) | 76 | 38 | 114 | 8.4 |

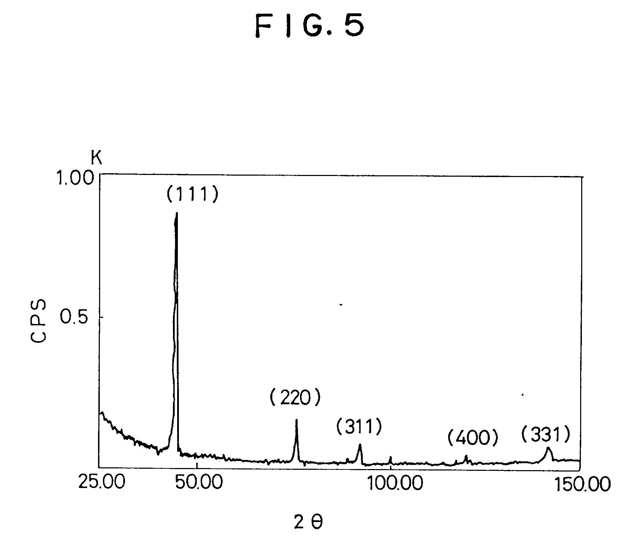

Next, the deposition procedure was repeated with diverse flow rates of the reactive gas through the reaction space. The inner area of the reaction chamber was 2207 cm. the power level of the microwave input was 2 kW to 8 kW. The substrate temperature was 800 °C. Table 2 shows the pressures (N/m and Torr) in the reaction space, the introduction rates (liters per minute) of hydrogen and methanol, the total introduction rates thereof and the flow speeds (centimeters per second) of the reactive gas. Table 3 shows the deposition speed (D.S.), the crystalline condition (C.C.), and the existence of graphite (E.G.). The existence of graphite was confirmed by Raman spectroscopic analysis. Hydrogen and methanol were supplied under atmospheric pressure respectively at 100 SCCM and 70 SCCM in the case of samples Nos. 1 to 5, at 100 SCCM and 100 SCCM for Nos. 6 to 10, at 100 SCCM and 200 SCCM for Nos. 11 to 15 and at 100 SCCM and 50 SCCM for Nos. 16 to 20. A microscopic photograph of Sample No. 3 (4kW) is shown in Fig. 4 for reference. The XRD (X-ray diffraction) spectra of Sample No. 3 is shown in Fig. 5. As may be seen from the spectra, count peaks appeared corresponding to crystalline planes of diamond.

**Table 3**

| No. | D.S. | C.C. | E.G. | D.S. | C.C. | E.G. |
|---|---|---|---|---|---|---|
| (Input Energy = 2kW) | | | | (Input Energy = 4kW) | | |
| 1 | < 0.1 | -- | -- | 0.25 | ⓞ | no |
| 2 | 0.93 | ⓞ | no | 0.45 | ⓞ | no |
| 3 | 0.4 | ⓞ | no | 0.65 | ⓞ | no |
| 4 | 0.48 | ◇ | no | 0.85 | ◇ | no |
| 5 | 0.65 | X | yes | -- | X | yes |

| (Input Energy = 2kW) | | | | (Input Energy = 4kW) | | |
|---|---|---|---|---|---|---|
| 6 | 0.8 | ⓞ | no | 1.5 | ⓞ | no |
| 7 | 1.0 | ⓞ | no | 1.7 | ⓞ | no |
| 8 | 1.7 | ⓞ | no | 2.3 | ◇ | no |
| 9 | -- | ◇ | yes | -- | X | yes |
| 10 | | | | | | |

| (Input Energy = 2kW) | | | | (Input Energy = 4kW) | | |
|---|---|---|---|---|---|---|
| 11 | 1.9 | ⓞ | no | 2.5 | ⓞ | no |
| 12 | 2.7 | ⓞ | no | 3.2 | ⓞ | no |
| 13 | 3.5 | ◇ | no | 4.5 | ◇ | no |
| 14 | -- | ◇ | yes | 5.3 | X | yes |
| 15 | | | | | X | |

| (Input Energy = 2kW) | | | | (Input Energy = 4kW) | | |
|---|---|---|---|---|---|---|
| 16 | < 0.1 | -- | - | 0.15 | ⓞ | no |
| 17 | 0.2 | ⓞ | no | 0.3 | ⓞ | no |
| 18 | 0.35 | ⓞ | no | 0.5 | ⓞ | no |
| 19 | 0.58 | ◇ | no | 0.7 | ◇ | yes |
| 20 | 0.9 | ◇ | no | 0.95 | X | yes |

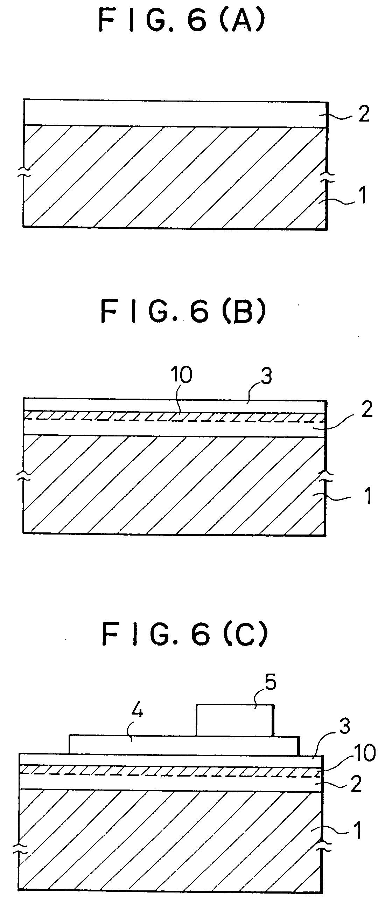

Referring now to Fig. 6, a method of forming a light emitting device utilizing the present invention will be explained. A diamond coating 2 is deposited on a p-type silicon semiconductor substrate 1 of a 10 cm (4-inch) wafer to a thickness of 0.5 to 3.0 micrometers, e.g. 1.3 micrometers, by the microwave-assisted plasma CVD method in a magnetic field as described above. During the deposition, B(CH₃)₃ is introduced as a dopant gas together with CH₃OH diluted by hydrogen at a volume ratio of CH₃OH/H₂ of 0.8. The volume ratio of B(CH₃)₃/CH₃OH was 0.03. The oxygen concentration of the diamond film was 1 x 10¹⁸ to 6 x 10⁰ cm⁻³. The diamond film is then scratched as indicated at 10 by bombarding its surface with diamond powder. The scratches 10 form focuses for the growth of diamond crystals. On the scratched surface, diamond deposition is carried out again to form a second diamond film 3 with a thickness of 0.5 micrometer. The reactive gas in this deposition consists of H₂, CH₃OH and (CH₃)₂S introduced at volume ratios of (CH₃)₂S/CH₃OH of 0.03 and CH₃OH/H₂ of 0.7. Then, an upper transparent electrode 4 made of indium tin oxide (ITO) and a conductor electrode 5 are deposited by vapour evaporation or sputtering. The conductor electrode 5 may be a multilayered metallic film consisting of, e.g. aluminium, silver, chromium and/or molybdenum films. The upper electrode 4 is severed by laser scribing into a number of 0.6 mm x 0.6 mm segments on each of which the conductor electrode 5 of 0.15 mm diameter is formed. The width of the scribing lines is 100 micrometers. Accordingly, 5000 light emitting elements of 1 mm x 1 mm are formed within the 10 cm (4-inch) wafer except for a margin of 4 mm.

By means of this structure, light emission can be realized by causing electrical current to pass through the diamond crystals of the film. The current induces recombination of electron-hole pairs between mid-gap states (radiation centers), between the mid-gap states and a valence band, between a conduction band and the mid-gap states and between the conduction band and the valence band. Oxygen atoms automatically introduced function as radiation centers. The spectrum of light emitted from a diamond film is determined by differential energy levels between the mid-gap states, the bottom of the conduction band and the apex of the valence band. Depending upon the differential levels, it is possible to emit blue or green light or radiation having a continuous spectrum of wavelengths over a relatively wide range such as white light.

When a voltage of 10 to 200 V (e.g. 60 V) was applied across the diamond film 3 of a diamond light emitting device formed in accordance with the above procedure, by means of the upper electrode 4 and with the substrate 1 functioning as a counterpart lower electrode, the diamond emitted a green visible light at 6 cd/m by virtue of the current passing therethrough. The voltage may be applied as a DC voltage or as a pulse train at no higher than 100 Hz with a duty ratio of 50%. When products capable of emitting light at no lower than 5 cd/m were regarded as acceptable, a yield of no lower than 85% was obtained.

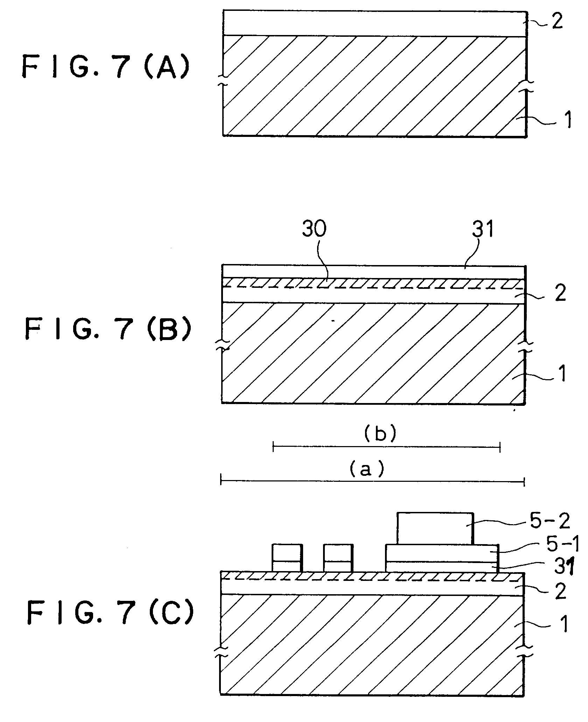

Referring now to Fig. 7, a modification of the example shown in Fig. 6 will be described. A boron-doped diamond coating 2 is deposited on a p-type silicon semiconductor substrate 1 of a 10 cm (4-inch) wafer to a thickness of 1.3 micrometers in the same manner as described above. An element of Group Vb is introduced into the surface of the diamond film 2 to form a doped surface 30 by ion implantation. On the doped surface 30, deposition is carried out again to form a silicon carbide film 31 of n-type conductivity with a thickness of 0.5 micrometer. The reactive gas in this deposition consists of H₂, CH₃OH, SiH₄ and PH₃ introduced at volume ratios of SiH₄/CH₃OH = PH₃/CH₃OH = 0.03 and CH₃OH/H₂ = 0.7. An n-type silicon semiconductor film may be deposited in place of the silicon carbide film 31 by omitting the use of the alcohol. Then, an upper transparent electrode 5-1 made of a thin chromium film and a conductor electrode 5-2 are deposited by vapour evaporation or sputtering. The electrode 5 may be a multilayered metallic film consisting of, e.g. aluminium. The upper electrode 5-1 is sectioned into a number of 0.6 mm x 0.6 mm effective regions (region (b) in the figure) by etching with a suitable photoresist mask. Within each effective region, the upper electrode 5-1 is patterned to form a plurality of strips. At the same time, the second film 31 is etched with the same mask. The electrode 5 of 0.1 mm x 0.1 mm is formed in each effective region. Accordingly, nearly 10000 light emitting elements of 0.8 mm x 0.8 mm (region (a) in the figure) are formed within the 10 cm (4-inch) wafer except for a margin of 4 mm. When 40 V was applied between the electrode 5-1 and the substrate 1, 20 cd/cm light emission was observed.

The foregoing description of preferred embodiments has been presented for purposes of illustration and description. It is not intended to be exhaustive or to limit the invention to the precise forms described, and obviously many modifications and variations are possible in the light of the above teaching. The embodiments have been chosen in order to explain most clearly the principles of the invention and its practical application thereby to enable others in the art to utilize most effectively the invention in various embodiments and with various modifications as are suited to the particular use contemplated. Although in the above examples alcohols are used as the carbon compound reactive gas, other carbon compounds having a C-OH bond can be used. Examples include compounds having benzene rings such as C₆(OH)₆, C₆H₃(OH)₃, etc, or mixtures of compounds having a C-OH bond and another carbon compound having a C=C bond such as C₂H₂ mixed with CH₃OH. These carbon compounds are used by diluting with hydrogen. The deposition speed can be improved by a factor of 2 to 5 by the use of these alternatives. The cost of the reactive gas, however, becomes more expensive in these cases.

The present invention is broadly applicable to any electrical device comprising a diamond film. These electrical devices can be formed on a single substrate, i.e. an integrated circuit device which may consist of diamond light emitting devices, diamond diodes, diamond transistors, diamond resistances, diamond capacitors and the like. Of course, it is possible to sever a single substrate, after a number of diamond devices are formed on the substrate, into individual separate devices.

## Claims

1. A method of depositing diamond comprising:
disposing a substrate (1) to be coated within a reaction chamber (19);
introducing a carbon compound gas including a C-OH bond together with hydrogen into the reaction chamber (19);
inducing a magnetic field in said reaction chamber (19); and
inputting microwave energy to said reaction chamber (19) in order to deposit a carbon film (2) comprising diamond on said substrate (1);
the volume ratio of said carbon compound gas to hydrogen introduced into said reaction chamber being 0.4 to 2, the pressure in said reaction chamber being 1.3 to 400 N/m (0.01 to 3 Torr), the temperature of said substrate being kept between 200 to 1000 °C during deposition, and the input energy of said microwave being no lower than 2 kW.

2. A method according to claim 1 wherein the substrate temperature is kept between 300 to 900 °C.

3. A method according to claim 1 or 2 wherein the pressure is 13 to 133 N/m (0.1 to 1 Torr).

4. A method according to claim 1 or 2 or 3 wherein the inside of said reaction chamber (19) is evacuated to 1.3 x 10⁻ to 1.3 x 10⁻¹⁵ N/m (10⁻⁴ to 10⁻¹⁷ Torr) in advance of said introducing step.

5. A method according to any preceding claim wherein a dopant gas is introduced into said chamber (19) together with said carbon compound gas and hydrogen.

6. A method according to claim 5 wherein said dopant gas is a boron compound gas.

7. A method according to any preceding claim wherein the microwave energy input during deposition and the pressure applied to said carbon compound gas are controlled in order to deposit a diamond film (2) containing a predetermined concentration of oxygen atoms on said substrate (1).

8. A method according to claim 7 wherein the predetermined concentration of oxygen atoms in said diamond film (2) is 1 x 10¹⁸ to 6 x 10⁰ cm⁻³.

9. A method according to claim 7 or 8 wherein a dopant gas comprising a C-B bond is introduced together with said carbon compound gas.

10. A method according to claim 9 wherein said dopant gas is B(CH₃)₃.

11. A method according to any of claims 1 to 4, 7 and 8 wherein a dopant gas comprising a hydrogen compound or carbide of sulphur, selenium or tellurium is introduced into said reaction chamber (19) together with said carbon compound gas.

12. A method according to any preceding claim wherein said carbon compound gas and hydrogen are introduced so as to pass through said reaction chamber (19) at an average flow speed of 30 cm/sec to 600 cm/sec.

13. A light emitting device comprising a first diamond film (2) formed on a silicon substrate (1) and a second diamond film (3) formed on said first diamond film (2), at least said first diamond film (2) being obtainable by a method according to any preceding claim and excluding unwanted impurities by virtue of said carbon compound gas including a C-OH bond.

14. A device according to claim 13 wherein scratches (10) are provided at the interface between said first and second films (2,3).

15. A device according to claim 13 or 14 wherein a dopant of a group VIb element such as S, Se or Te is introduced into at least one of said diamond films (2,3).

16. A light emitting device comprising a diamond film (2) formed on a p-type silicon semiconductor substrate (1), and an n-type semiconductor film (31) made of silicon carbide or silicon formed on said diamond film (2), said diamond film being obtainable by a method according to any of claims 1 to 14 and excluding unwanted impurities by virtue of said carbon compound gas including a C-OH bond.

17. A device according to claim 16 wherein said diamond film (2) contains impurities functioning as light emission centers or recombination centers.

18. A method of manufacturing a diamond light emitting device comprising:
depositing a diamond film (2) on a p-type semiconductor substrate (1) by a method according to any of claims 1 to 14 said diamond film (2) excluding unwanted impurities by virtue of said carbon compound gas including a C-OH bond;
forming an n-type semiconductor film (31) made of silicon carbide or silicon on said diamond film (2); and
forming an electrode arrangement (5-1,5-2) on said semiconductor film (31).

## Patentansprüche

1. Verfahren zum Ablagern von Diamant, umfassend:
- Anordnen eines zu beschichtenden Substrats (1) innerhalb einer Reaktionskammer (19);
- Einleiten eines Gases einer Kohlenstoffverbindung, die eine C-OH-Bindung enthält, zusammen mit Wasserstoff in die Reaktionskammer (19);
- Induzieren eines Magnetfelds in der Reaktionskammer (19) und
- Einleiten von Mikrowellenenergie in die Reaktionskammer (19), um einen Diamant enthaltenden Kohlenstoffilm (2) auf dem Substrat (1) abzulagern;
- wobei das Volumenverhältnis des Kohlenstoffverbindungsgases zu Wasserstoff, wie in die Reaktionskammer eingeleitet, 0,4 bis 2 beträgt, der Druck in der Reaktionskammer 1,3 bis 400 N/m (0,01 bis 3 Torr) beträgt, die Temperatur des Substrats während der Ablagerung zwischen 200 und 1000°C gehalten wird und die Eingangsleistung der Mikrowelle nicht unter 2 kW beträgt.

2. Verfahren nach Anspruch 1, bei dem die Substrattemperatur zwischen 300 und 900°C gehalten wird.

3. Verfahren nach einem der Ansprüche 1 oder 2, bei dem der Druck 13 bis 133 N/m (0,1 bis 1 Torr) beträgt.

4. Verfahren nach einem der Ansprüche 1 oder 2 oder 3, bei dem das Innere der Reaktionskammer (19) vor dem Einleitungsschritt auf 1,3 x 10⁻ bis 1,3 x 10⁻¹⁵ N/m (10⁻⁴ bis 10⁻¹⁷ Torr) abgepumpt wird.

5. Verfahren nach einem der vorstehenden Ansprüche, bei dem ein Dotiergas zusammen mit dem Kohlenstoffverbindungsgas und Wasserstoff in die Kammer (19) eingeleitet wird.

6. Verfahren nach Anspruch 5, bei dem das Dotiergas ein Borverbindungsgas ist.

7. Verfahren nach einem der vorstehenden Ansprüche, bei dem die während der Ablagerung eingeleitete Mikrowellenenergie sowie der Druck des Kohlenstoffverbindungsgases eingestellt werden, um einen Diamantfilm (2) auf dem Substrat (1) abzulagern, der eine vorgegebene Konzentration an Sauerstoffatomen enthält.

8. Verfahren nach Anspruch 7, bei dem die vorgegebene Konzentration an Sauerstoffatomen im Diamantfilm (2) 1 x 10¹⁸ bis 6 x 10⁻⁰ cm⁻³ beträgt.

9. Verfahren nach einem der Ansprüche 7 oder 8, bei dem ein eine C-B-Bindung enthaltendes Dotiergas zusammen mit dem Kohlenstoffverbindungsgas eingeleitet wird.

10. Verfahren nach Anspruch 9, bei dem das Dotiergas B(CH₃)₃ ist.

11. Verfahren nach einem der Ansprüche 1 bis 4, 7 und 8, bei dem ein eine Wasserstoffverbindung oder ein Carbid von Schwefel, Selen oder Tellur enthaltendes Dotiergas zusammen mit dem Kohlenstoffverbindungsgas in die Reaktionskammer (19) eingeleitet wird.

12. Verfahren nach einem der vorstehenden Ansprüche, bei dem das Kohlenstoffverbindungsgas und Wasserstoff so eingeleitet werden, daß sie mit einer mittleren Strömungsgeschwindigkeit von 30 cm/Sek. bis 600 cm/Sek. durch die Reaktionskammer (19) laufen.

13. Lichtemittierendes Bauteil mit einem ersten auf einem Siliziumsubstrat (1) hergestellten Diamantfilm (2) und einem auf diesem ersten Diamantfilm (2) hergestellten zweiten Diamantfilm (3), wobei zumindest der erste Diamantfilm (2) durch ein Verfahren gemäß einem der vorstehenden Ansprüche erhalten wird, wobei unerwünschte Fremdstoffe mittels des eine C-OH-Bindung enthaltenden Kohlenstoffverbindungsgases ausgeschlossen sind.

14. Bauteil nach Anspruch 13, bei dem an der Grenzfläche zwischen dem ersten und dem zweiten Film (2, 3) Kratzer (10) vorhanden sind.

15. Bauteil nach einem der Ansprüche 13 oder 14, bei dem ein Dotierstoff eines Elements der Bruppe VIb, wie S, Se oder Te in mindestens einen der Diamantfilme (2, 3) eingeführt wird.

16. Lichtemittierendes Bauteil mit einem auf einem Halbleitersubstrat (1) aus p-Silizium hergestellten Diamantfilm (2) und einem auf dem Diamantfilm (2) hergestellten N-Halbleiterfilm (31) aus Siliziumcarbid oder Silizium, wobei der Diamantfilm durch ein Verfahren gemäß einem der Ansprüche 1 bis 14 herstellbar ist und er mittels des eine C-OH-Bindung enthaltenden Kohlenstoffverbindungsgases unerwünschte Fremdstoffe ausschließt.

17. Bauteil nach Anspruch 16, bei dem der Diamantfilm (2) Fremdstoffe enthält, die als Lichtemissionszentren oder Rekombinationszentren wirken.

18. Verfahren zum Herstellen eines lichtemittierenden Bauteils aus Diamant, umfassend:
- Ablagern eines Diamantfilms (2) auf einem p-Halbleitersubstrat (1) mittels eines Verfahrens gemäß einem der Ansprüche 1 bis 14, wobei der Diamantfilm (2) mittels des eine C-OH-Bindung enthaltenden Kohlenstoffverbindungsgases unerwünschte Fremdstoffe ausschließt;
- Herstellen eines n-Halbleiterfilms (31) aus Siliziumcarbid oder Silizium auf dem Diamantfilm (2) und
- Herstellen einer Elektrodenanordnung (5-1, 5-2) auf dem Halbleiterfilm (31).

## Revendications

1. Procédé pour le dépôt de diamant comprenant les étapes consistant à:
disposer un substrat (1) à revêtir d'un dépôt à l'intérieur d'une chambre de réaction (19);
introduire un gaz de composé de carbone incluant un liant C-OH ensemble avec de l'hydrogène dans la chambre de réaction (19);
induire un champ magnétique dans ladite chambre de réaction (19); et
introduire une énergie micro-onde dans ladite chambre de réaction (19) afin de déposer un film de carbone (2) comprenant du diamant sur ledit substrat (1);
le rapport des volumes dudit gaz de composé de carbone relativement à l'hydrogène introduits dans ladite chambre de réaction étant compris entre 0,4 et 2, la pression dans ladite chambre de réaction étant comprise entre 1,3 et 400 N/m (0,01 à 3 Torr), la température dudit substrat étant maintenue entre 200 et 1000°C pendant le dépôt, et l'énergie d'entrée de ladite micro-onde n'étant pas inférieure à 2 kW.

2. Procédé selon la revendication 1, dans lequel la température du substrat est maintenue entre 300 et 900°C.

3. Procédé selon la revendication 1 ou 2, dans lequel la pression est de 13 à 133 N/m (0,1 à 1 Torr).

4. Procédé selon la revendication 1 ou 2 ou 3, dans lequel l'intérieur de ladite chambre de réaction (19) est vidé à une pression de 1,3x10⁻ à 1,3x10⁻¹⁵ N/m (10⁻⁴ a 10⁻¹⁷ Torr) avant ladite étape d'introduction.

5. Procédé selon l'une quelconque des revendications précédentes, dans lequel un gaz dopant est introduit dans ladite chambre (19) ensemble avec ledit gaz de composé de carbone et l'hydrogène.

6. Procédé selon la revendication 5, dans lequel ledit gaz dopant est un gaz de composé de bore.

7. Procédé selon l'une quelconque des revendications précédentes, dans lequel l'énergie micro-onde introduite pendant le dépôt et la pression appliquée audit gaz de composé de carbone sont commandées afin de déposer un film de diamant (2) contenant une concentration prédéterminée d'atomes d'oxygène sur ledit substrat (1).

8. Procédé selon la revendication 7, dans lequel la concentration prédéterminée d'atomes d'oxygène dans ledit film de diamant (2) est de 1x10¹⁸ à 6x10⁰ cm⁻³.

9. Procédé selon la revendication 7 ou 8, dans lequel un gaz dopant comprenant un liant C-B est introduit ensemble avec ledit gaz de composé de carbone.

10. Procédé selon la revendication 9, dans lequel ledit gaz dopant est le B(CH₃)₃.

11. Procédé selon l'une quelconque des revendications 1 à 4, 7 et 8, dans lequel un gaz dopant comprenant un composé de l'hydrogène ou du carbure de soufre, du sélénium ou du tellure, est introduit dans ladite chambre de réaction (19) ensemble avec ledit gaz de composé de carbone.

12. Procédé selon l'une quelconque des revendications précédentes, dans lequel ledit gaz de composé de carbone et l'hydrogène sont introduits de manière à traverser ladite chambre de réaction (19) à une vitesse moyenne d'écoulement de 30 cm/s à 600 cm/s.

13. Dispositif d'émission de lumière comprenant un premier film de diamant (2) formé sur un substrat de silicium (1) et un second film de diamant (3) formé sur ledit premier film de diamant (2), au moins ledit premier film de diamant (2) pouvant être obtenu par un procédé selon l'une quelconque des revendications précédentes et excluant des impuretés non voulues grâce audit gaz de composé de carbone incluant un liant C-OH.

14. Dispositif selon la revendication 13, dans lequel des rayures (10) sont prévues au niveau de la partie de liaison entre lesdits premier et second films (2, 3).

15. Dispositif selon la revendication 13 ou 14, dans lequel un dopant constitué d'un élément du groupe VIb, tel que le S, le Se ou le Te, est introduit dans au moins l'un desdits films de diamant (2, 3).

16. Dispositif d'émission de lumière comprenant un film de diamant (2) formé sur un substrat semi-conducteur de silicium de type P (1), et un film semi-conducteur de type N (31) constitué de carbure de silicium ou de silicium formé sur ledit film de diamant (2), ledit film de diamant pouvant être obtenu par un procédé selon l'une quelconque des revendications 1 à 14 et excluant des impuretés non voulues grâce audit gaz de composé de carbone incluant un liant C-OH.

17. Dispositif selon la revendication 16, dans lequel ledit film de diamant (2) contient des impuretés fonctionnant comme centres d'émission de lumière ou centres de recombinaison.

18. Procédé pour fabriquer un dispositif d'émission de lumière au diamant comprenant les étapes consistant à:
déposer un film de diamant (2) sur un substrat semi-conducteur de type P (1) par un procédé selon l'une quelconque des revendications 1 à 14, ledit film de diamant (2) excluant des impuretés non voulues grâce audit gaz de composé de carbone incluant un liant C-OH;
former un film semi-conducteur de type N (31) constitué de carbure de silicium ou de silicium sur ledit film de diamant (2); et
former une disposition d'électrodes (5-1, 5-2) sur ledit film semi-conducteur (31).
